# EUROPÄISCHE PATENTSCHRIFT

(11) **EP 1 112 484 B1**
(45) Veröffentlichungstag und Bekanntmachung des Hinweises auf die Patenterteilung: **25.06.2003**
(21) Anmeldenummer: 99952317.8
(22) Anmeldetag: 10.08.1999
(51) Int. Cl.: G01N 21/88

(54) **VORRICHTUNG ZUR VERMESSUNG VON WERKSTÜCKEN MIT EINER BILDVERARBEITUNGSANLAGE**
DEVICE FOR MEASURING WORK PIECES USING AN IMAGE PROCESSING SYSTEM
DISPOSITIF POUR MESURER DES PIECES AVEC UN SYSTEME DE TRAITEMENT D'IMAGES

(30) Priorität: 14.08.1998 DE 19836925
(43) Veröffentlichungstag der Anmeldung: 04.07.2001
(73) Patentinhaber: Visicontrol Gesellschaft für elektronische Bildverarbeitung mbH, 88250 Weingarten (DE)
(72) Erfinder: HEIBERGER, Lothar, D-88410 Bad Wurzach (DE)
(74) Vertreter: Patentanwälte Eisele, Otten & Roth
(86) Internationale Anmeldenummer: DE9902460
(87) Internationale Veröffentlichungsnummer: WO00009992

(56) Entgegenhaltungen:
- WO-A-99/17599
- DE-U- 8 916 151
- US-A- 5 307 149
- US-A- 5 563 703

## Beschreibung

Die Erfindung betrifft eine Vorrichtung zur Vermessung von Werkstücken mit einer Bildverarbeitungsanlage nach dem Oberbegriff des Anspruchs 1.

Bei der Vermessung von Werkstücken mit einer Bildverarbeitungsanlage wird in der Regel das zu überprüfende Werkstück auf einem Träger aufgelegt, dort beleuchtet und mit Hilfe einer Kamera beobachtet. Im Falle einer Schwarzweißkamera ergeben sich dementsprechend punktweise digitale Bildinformationen in Form von Grauwerten.

Um einen bestimmten Prüfpunkt, beispielsweise einen Lötpin eines Chipsockels in seiner Form oder Lage zum Chipgehäuse zu vermessen, wird üblicherweise die Vorderkante des Chipgehäuses, die auf dem Träger aufliegt, als Bezugskante genommen und die Höhe des im Bild erkennbaren Meßpunktes, z. B. der Mittelpunkt der Unterkante eines Lötpins, über dieser Bezugskante durch entsprechende Auswertung der Bildkoordinaten ermittelt.

Je nach Materialauswahl oder räumlicher Struktur des Werkstücks ist es jedoch möglich, daß sich keine scharfe Kontrastlinie im Auflagebereich auf dem Träger ausbildet. Dies ist beispielsweise dann der Fall, wenn ein zu prüfender Chipsockel in diesem Bereich eine Krümmung, eine sogenannte Bombierung, aufweist. In diesem Fall ergibt sich im Auflagebereich eine Übergangszone zwischen hellen und dunklen Werten in dem aufgenommenen Bild. Durch die Breite dieser Übergangszone ergeben sich dementsprechend Meßungenauigkeiten in den Koordinaten der Meßpunkte, die mit Bezug auf diese nicht scharf erkennbare Auflagekante bestimmt werden.

Die Druckschrift US-A-5,563,703 offenbart eine Vorrichtung zur Vermessung von Werkstücken mit einer Bildverarbeitungsanlage, die eine Kamera, eine Auswerteeinheit und einen Träger zur Positionierung der Werkstücke vor der Kamera aufweist, wobei der Träger eine Markierung als Bezugspunkt für die Ermittlung der gewünschten Werkstückkoordinaten und eine definierte Auflagefläche für das Werkstück aufweist.

Die Druckschrift WO-A-99 17 599 beschreibt eine Vorrichtung zur Lageerkennung von Kanten von Bauelementen mit einer Bildverarbeitungsanlage, die eine Kamera, eine Auswerteeinheit und einen Träger zur Positionierung der Bauelemente vor der Kamera aufweist, wobei der Träger eine Markierung als Bezugspunkt für die Ermittlung der gewünschten Koordinaten und eine definierte Fläche für die Positionierung der Bauelemente aufweist.

Die Druckschrift DE 89 16 151.3 zeigt eine Anordnung zur Lageerkennung von Anschlußbeinchen elektronischer Bauelemente mittels Positionierung der elektronischen Bauelemente auf einer lichtdurchlässigen Platte bei gleichzeitiger Beleuchtung der Anschlußbeinchen und Auswertung mittels eine Bildverarbeitungsanlage.

Aufgabe der Erfindung ist es, eine Vorrichtung vorzuschlagen, die eine exakte Messung auch bei nicht scharf sichtbarem Rand der zu vermessenden Werkstücks ermöglicht, die leicht zu reinigen ist und eine hohe Lebensdauer aufweist.

Diese Aufgabe wird ausgehend von einer Vorrichtung der einleitend genannten Art durch die Merkmale des Anspruchs 1 gelöst.

Durch die in den Unteransprüchen genannten Maßnahmen sind vorteilhafte Ausführungen und Weiterbildungen der Erfindung möglich.

Dementsprechend zeichnet sich eine erfindungsgemäße Vorrichtung dadurch aus, daß der Träger für das zu vermessende Werkstück wenigstens eine Markierung als Bezugspunkt für die Ermittlung der gewünschten Werkstückkoordinaten und eine definierte Auflagefläche für das Werkstück aufweist, deren Koordinaten bezüglich der Markierung wenigstens teilweise in der Bildverarbeitungsanlage gespeichert sind.

Die erfindungsgemäße Markierung ist so ausgebildet, daß sie hochgenau mit Hilfe der Bildverarbeitungsanlage erfassbar ist. In der Auswerteeinheit kann demnach ein Koordinatensystem mit festem Bezug zu der bzw. den Markierungen erzeugt werden. Anschließend können die zu vermessenden Punkte am zu prüfenden Werkstück in Bezug zu diesem Koordinatensystem ermittelt werden.

Da die Koordinaten der Auflagefläche des Trägers in Bezug zur Markierung, die zuvor ermittelt wurden, gespeichert und somit bekannt sind, ist nunmehr die Auswerteeinheit in der Lage, die Koordinaten des Meßpunkts bzw. der Meßpunkte in Bezug zur Außenkontur des zu prüfenden Werkstücks zu bestimmen.

Mit Hilfe eines erfindungsgemäß markierten Trägers ist daher die Vermessung eines Werkstücks möglich, auch wenn keine scharfe Randlinie im Bereich der Auflage auf dem Träger in dem aufgenommenen Bild erkennbar ist.

Die Erfindung umfaßt weiterhin die Ausbildung der Markierung als Einlegeteil. Ein derartiges Einlegeteil kann aus einem Material gebildet sein, das verschleißfest und leicht zu reinigen ist.
Hierdurch ist ein Einlegeteil gegenüber einer Farbmarkierung oder einer Prägemarkierung von Vorteil, da diese bei mehrfachen Reinigungsvorgängen aufgrund von Verschmutzungen entsprechend verschleißen können.

Vorzugsweise wird das Einlegeteil als Kugel ausgebildet. Ein kugelförmiges Einlegeteil ist besonders leicht in das Trägermaterial einzubringen, in dem eine Bohrung angebracht wird, in die die Kugel eingelegt wird. Insbesondere ist bei einer Kugel die Winkelorientierung des Einlegeteils beim Einlegen ohne Belang. Mit Hilfe der Bildauswertung kann daher leicht ein Referenzpunkt bestimmt werden, beispielsweise der Mittelpunkt oder aber der Berührungspunkt, an dem die Verbindungsgerade zwischen zwei Markierungskugeln als Tangente anliegt. Durch die Kugelform sind die entsprechenden Rechenalgorithmen besonders einfach.

In einer besonders vorteilhaften Ausführungsform der Erfindung werden wenigstens zwei Markierungen am Träger angebracht. Mit zwei Markierungen läßt sich bereits ein zweidimensionales kartesisches Koordinatensystem erzeugen, indem eine Gerade zwischen den Markierungen und eine Senkrechte hierzu bestimmt wird.

Vorzugsweise wird die Auswerteeinheit der Bildverarbeitungsanlage dergestalt ausgebildet, daß sie den Abstand zwischen dem zu vermessenden Meßpunkt und einer durch die Markierung bestimmten Bezugsgeraden ermittelt. Im Falle eines Koordinatensystems, das als Abszisse die Verbindungsgerade zwischen zwei erfindungsgemäßen Markierungen bildet, ist dieser Abstand unmittelbar durch einen Koordinatenwert gegeben.

In einer Weiterbildung der Erfindung werden die beiden Markierungen möglichst außerhalb des Meßbereichs angebracht, da hierdurch die Verbindungsgerade, insbesondere im Hinblick auf ihre Winkellage, genauer bestimmbar ist.

Weiterhin wird die Auswerteeinheit bevorzugt so ausgebildet, daß sie die tatsächliche Lage des Meßpunktes bezüglich der Kontur des Werkstücks aus dem Abstand des Meßpunkts von der Bezugsgeraden unter Berücksichtigung der gespeicherten Trägerkoordinaten ermittelt. In einer besonderen Anwendungsform der Erfindung wird beispielsweise der Abstand des Meßpunktes über der Bezugsgeraden, wie oben angeführt, ermittelt und der mit Hilfe der gespeicherten Trägerkoordinaten bestimmbare Abstand der Auflagefläche von der Bezugsgeraden davon abgezogen.

In einer Weiterbildung der Erfindung werden die Trägerkoordinaten mit Hilfe eines Eichkörpers ermittelt, der auf die Auflagefläche des Trägers aufgelegt wird. Ein derartiger Eichkörper kann hochgenau gefertigt und gegebenenfalls wiederum mit entsprechenden Eichmarkierungen versehen werden.

Vorteilhafterweise wird ein Streuelement zur Erzeugung einer homogen diffusen Beleuchtung am Träger vorgesehen. Besonders geeignet sind hierfür einige Kunststoffe, die aufgrund ihres Materialaufbaus zumindest teilweise transparent für die Beleuchtung sind, jedoch aufgrund der Vielzahl der durch den Materialaufbau gebildeten Streuzentren ein weißes, trübes bzw. milchiges Aussehen haben.

Vorzugsweise wird weiterhin der Träger teilweise aus klarem transparentem Material gefertigt. Hierdurch kann dieser Teil des Trägers mit erhöhter Stabilität gefertigt und dennoch ohne großen Intensitätsverlust durchleuchtet werden. In dem klaren, transparenten Material findet weniger Verlust der angestrahlten Intensität im Vergleich zu einem trüben Streuelement statt. Bei einem Träger, der aus beiden Materialien kombiniert wird, findet auch bei großer und entsprechend stabiler Materialstärke eine ausreichende Beleuchtung durch den Träger mit dem gewünschten diffusen Licht statt.

In einer weiteren vorteilhaften Ausführungsform werden ein oder mehrere Blenden zum Ausblenden der Beleuchtung in bestimmten Bereichen vorgesehen. So kann es beispielsweise sinnvoll sein, bei der Vermessung von Lötpins an Chiphaltern den Bereich unterhalb der Lötpins von der Beleuchtung auszublenden. Generell sind derartige Blenden sinnvoll, wo schräge Reflexionsflächen am zu prüfenden Gegenstand vorhanden sind, die unerwünschte Reflexionen in die Kamera hervorrufen können.

Vorzugsweise werden diese Blenden als schwarze Einlegeteile im Träger ausgeführt. In Frage kommen hier beispielsweise schwarze Kunststoffteile, die eine gute Verbindung mit den anderen Kunststoffmaterialien des Trägers eingehen können.

Weiterhin ist es von Vorteil, Positionselemente für eine definierte Montageposition des Trägers auf einer Halterung vorzusehen. Diese präzis reproduzierbare Montageposition ist erforderlich, um die mit den oben angeführten Maßnahmen erzielbare Genauigkeit nicht durch einen zu großen Fehler in der Montageposition wieder zu verschlechtern.

Diese Positionselemente können wiederum als Einlegeteil, beispielsweise auf der Unterseite des Trägers, ausgeführt werden und als Auflageelemente auf einer Haltefläche einer Halterung dienen.

Auch bei Positionselementen ist die Kugelform von Vorteil. Die Montage ist durch Eindrücken in entsprechende Bohrungen sehr einfach und außerdem unabhängig von der Winkelorientierung des Einlegeteils. Hierbei ist zu beachten, daß bei der Montage dieser Einlegeteile nicht die spätere Meßgenauigkeit eingehalten werden muß. Der fertige Träger wird auf der Halterung in der entsprechenden Prüfanlage mit Hilfe eines Eichkörpers geeicht, so daß entsprechende Schwankungen in der Lage dieser Einlegeteile bei der Eichung berücksichtigt und dementsprechend in der Auswertung des Meßergebnisses kompensiert werden können.

Ein weiterer Vorteil in der Verwendung von Kugeln als Positionierelemente ist die leichte und zuverlässige Zentrierung in einer entsprechenden Ansenkung der Halterung, auf der der Träger montiert wird. Die Reproduzierbarkeit der bei der Eichung vorliegenden Position wird hierdurch verbessert.

Vorzugsweise wird weiterhin eine Trägercodierung vorgenommen. Mit Hilfe der Trägerkodierung kann die Auswerteeinheit des Bilderfassungssystems ohne weitere separate Dateneingabe erkennen, auf welchem Träger das zu prüfende Teil aufgelegt ist, so daß die entsprechenden bei der Eichung ermittelten Trägerkoordinaten aus dem Datenspeicher abgerufen werden können.

Vorzugsweise wird auch die Trägerkodierung über Einlegeteile bewerkstelligt. Auch hierbei ergibt sich wiederum der Vorteil, daß ein Einlegeteil verschleißfest und schmutzempfindlich ausgebildet werden kann und dementsprechend auch nach mehrfacher Reinigung die Kodierung gut erkennbar ist. Darüber hinaus bietet die Verwendung von Einlegeteilen zur Kodierung in Verbindung mit Einlegeteilen als Markierung den Vorteil, daß die Kodierung in einem Arbeitsgang mit der Markierung der Träger vorgenommen werden kann.

Auch für die Trägerkodierung ist die Verwendung von Kugeln als Einlegeteil insbesondere durch das einfache Einlegen in eine Bohrung von Vorteil.

Eine Trägerkodierung kann beispielsweise dergestalt realisiert werden, daß zwei Einlegeteile zur Kodierung verwendet werden. Dementsprechend können durch Einsetzen oder Weglassen zweier Einlegeteile im binären System vier Zahlen dargestellt werden.

Gegebenenfalls können in einer Weiterbildung der Erfindung ein oder mehrere Einlegeteile zur Kodierung zugleich als erfindungsgemäße Markierung zur Bestimmung eines Bezugspunktes in der Bildauswertung während der Eichung miterfaßt und deren Koordinaten abgespeichert werden.

Für eine gute Reproduzierbarkeit der Meßergebnisse ist eine präzise Positionierung des zu vermessenden Teils auf dem Träger notwendig. Insbesondere müssen die beiderseitigen Auflageflächen gut aneinandergefügt werden. Um im vollautomatischen Betrieb eine genaue Position zu gewährleisten, werden vorteilhafterweise Saugkanäle im Träger vorgesehen, die in der Auflagefläche ausmünden und durch die mit Hilfe von Unterdruck das zu prüfende Teil angesaugt werden kann.

Ein Ausführungsbeispiel der Erfindung ist in der Zeichnung dargestellt und wird anhand der Figuren nachfolgend näher erläutert.

Im Einzelnen zeigen
- Fig. 1: eine Draufsicht auf einen erfindungsgemäßen Träger mit eingelegtem Chiphalter,
- Fig. 2: eine Seitenansicht eines erfindungsgemäßen Trägers mit eingelegtem Chiphalter gemäß Fig. 1,
- Fig. 3: eine Draufsicht auf einen weiteren erfindungsgemäßen Träger mit eingelegtem Chiphalter,
- Fig. 4: eine Seitenansicht eines erfindungsgemäßen Trägers mit eingelegtem Chiphalter gemäß Fig. 3.

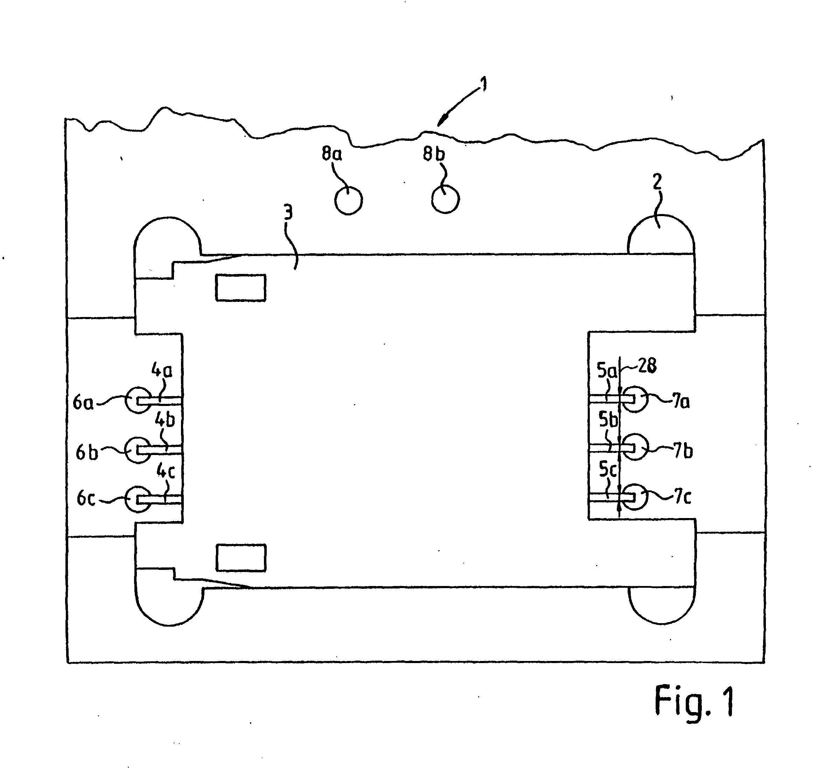

Der Träger 1 gemäß Fig. 1 weist eine Ausnehmung 2 auf, in die ein Chiphalter 3 eingelegt ist, der in Funk-Telefonen zur Aufnahme der Chipkarte für die Freischaltung verwendet wird. Der Chiphalter 3 wird mit seinen Lötpins 4a, b, c bzw. 5a, b, c auf der entsprechenden Platine verlötet. Um eine einwandfreie Verlötung zu gewährleisten, ist es erforderlich, daß die Lötpins 4a, b, c bzw. 5a, b, c exakt ausgerichtet sind und insbesondere in einer Ebene liegen.

In Fig. 1 sind weiterhin Markierungskugeln 6a, b, c bzw. auf der gegenüberliegenden Seite Markierungskugeln 7a, b, c erkennbar, auf deren Funktion weiter unten noch näher eingegangen wird. Die Markierungskugeln 6a, b, c bzw. 7a, b, c sind in entsprechende, in Fig. 1 durch die Kugeln 6a, b, c bzw. 7a, b, c ausgefüllte und daher nicht erkennbare Vertiefungen eingelegt.

Weiterhin sind in Fig. 1 zwei Bohrungen 8a, b erkennbar, die zur Kodierung des Trägers 1 dienen. Diese Kodierung kann beispielsweise so aussehen, daß die leeren Bohrungen 8a, b wie in Fig. 1 dargestellt als die Zahl 0 interpretiert werden. Die Besetzung der rechten Bohrung 8b mit einer Einlegekugel könnte als die Zahl 1, die Besetzung der Bohrung 8a bei freier Bohrung 8b als die Zahl 2 und die Besetzung beider Bohrungen 8a, b als die Zahl 3 interpretiert werden. Somit lassen sich durch diese Art der Kodierung vier unterschiedliche individuell geeichte Träger kennzeichnen.
Bei Bedarf können selbstverständlich weitere Kodierungsmaßnahmen, z. B. in Form einer oder mehrerer weiterer Bohrungen vorgenommen werden, um eine größere Anzahl unterschiedlicher Träger automatisch zu erkennen.

Durch die Maßlinien 28 wird veranschaulicht, daß in dieser Perspektive Maße wie z. B. der Pinabstand, die Pinstärke sowie andere in der Draufsicht sichtbare Maße des Chiphalters 3 vermessen werden können.

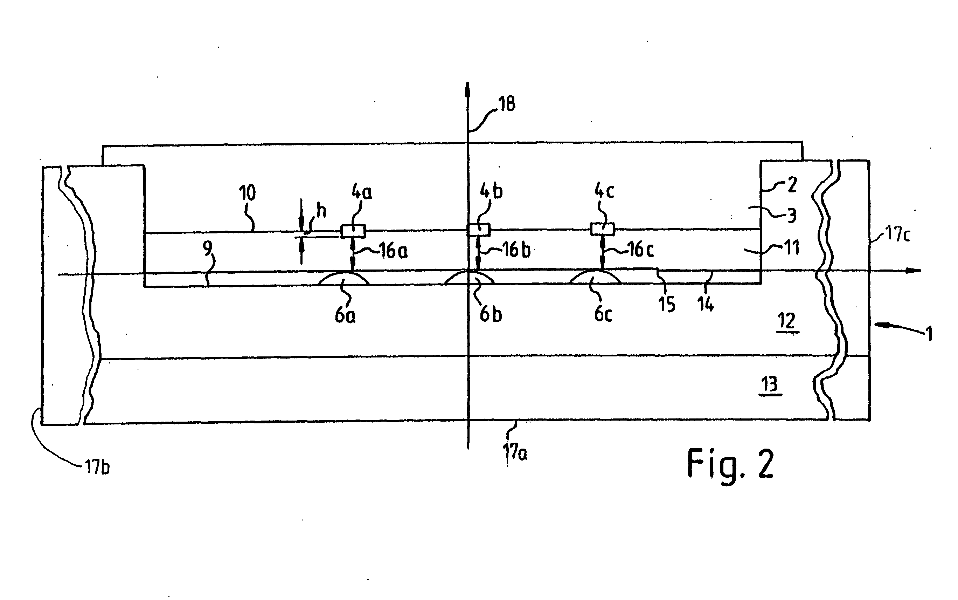

In der Seitenansicht gemäß Fig. 2 wird die Funktion der Markierungskugeln 6a, b, c deutlich. Die Markierungskugeln 6a, b, c stehen teilweise über die Einlegeebene 9 hervor, in der die entsprechenden, auch in der Seitenansicht nicht sichtbaren Bohrungen zur Aufnahme der Markierungskugeln 6a, b, c angebracht sind.

Der Chiphalter 3 liegt auf einer Auflageebene 10 auf, die gegenüber der Einlegeebene 9 abgestuft ist. Dementsprechend stehen die Lötpins 4a, b, c über der Einlegeebene 9 in der Luft und ragen ein Stück weit in den vertikalen Wandbereich 11 der Abstufung zwischen der Einlegeebene 9 und der Auflageebene 10 hinein.

Der Träger 1 ist aus einer als Streuelement dienenden durchlässig, trüben Streuplatte 12 und einer darunter fest mit der Streuplatte 12 verbundenen schwarzen Blende 13 aufgebaut. Im Seitenbereich der Blende 13 können außerhalb des dargestellten Bildausschnittes transparente, klare Verstärkungsplatten zur Erhöhung der Materialstabilität angebracht werden, die keine wesentlichen Intensitätsverluste bei der Beleuchtung verursachen. Dieses transparente Material kann sich auch über die Unterseite der Blende 13 erstrecken.

Die Beleuchtung erfolgt durch das Material der Streuplatte 12 hindurch, die aufgrund ihrer Formgebung sowie ihrer Materialstruktur mit sehr vielen Streuzentren für ein homogen diffuses Licht sorgt und so einen guten Kontrast im vertikalen Bereich 11 der Abstufung zwischen der Einlegeebene 9 und der Auflageebene 10 bewirkt. In der dargestellten Seitenansicht sind genau in diesem Bereich die Lötpins 4a, b, c sowie die Markierungskugeln 6a, b, c sehr gut sichtbar.

Erfindungsgemäß wird nun eine Bezugsgerade 14 als Tangente über die beiden äußeren Markierungskugeln 6a, c gelegt. Diese Bezugsgerade 14 verläuft in der Darstellung auf einem Computermonitor nicht exakt waagrecht und kann daher entsprechend Sprünge 15 in der bildlichen Darstellung aufweisen, die durch die beschränkten Darstellungsmöglichkeiten mit einem Pixel-Raster erzeugt werden. Die Bezugsgerade 14 wird rechnerisch vom Auswertesystem der Bildverarbeitungsanlage ermittelt.

Weiterhin ist in Fig. 2 durch Maßlinien 16a, b, c, angedeutet, daß die Auswerteeinheit den Abstand der Unterkante der Lötpins 4a, b, c von der Bezugsgerade 14 berechnet. Durch vorheriges Ausmessen des Trägers 1 bzw. dessen Auflageebene 10 mit Hilfe eines Eichkörpers in Bezug zur Bezugsgeraden 14 ist die Auflageebene 10 des Trägers 1 und dementsprechend auch die Höhe der unteren aufliegenden Randkontur des Chiphalters 3 bekannt, obwohl diese im Kamerabild aufgrund einer Rundung an der Kante des Chiphalters 3 nur unscharf zu erkennen ist.

Anstelle der unmittelbaren Messung der Auflageebene 10 wird nun das mit dem Eichkörper ermittelte Abstandsmaß von der Bezugsgeraden 14 an der gewünschten Meßstelle herangezogen und hiervon der während der Messung ermittelte Abstand der Lötpins 4a, b, c über der Bezugsgeraden 14 abgezogen. Hierdurch erhält man eine sehr genaue Messung des Überstandes h der Lötpins 4a, b, c, auch wenn die Auflagefläche 10 bzw. die Randkontur des Chiphalters 3 nicht scharf in der Bildverarbeitung zu bestimmen ist.

Dementsprechend kann auch die Koplanarität der einzelnen Lötpins 4a, b, c zueinander mit hoher Genauigkeit bestimmt werden und Chipträger 3 mit nicht koplanaren Pins 4a, b, c ausgesondert oder nachgearbeitet werden. Somit ist eine gute Verlötung und dementsprechend auch ein hoher Qualitätsstandard in der fertiggestellten Platine mit aufgelötetem Chipträger 3 gewährleistet.

Für das beschriebene Meßverfahren ist eine gut reproduzierbare Auflage des Chipträgers 3 auf der Auflagefläche 10 des Trägers 1 erforderlich, weshalb zum einen störende Verunreinigungen zu vermeiden sind und zum anderen aber auch nicht näher dargestellte Saugkanäle im Träger 1 angebracht werden können, die auf der Unterseite der Auflagefläche 10 ausmünden und durch Unterdruck für einen formschlüssig anliegenden Sitz des angesaugten Chiphalters 3 auf der Auflagefläche 10 sorgen.

Um den Träger 1 in einer entsprechenden Halterung ebenfalls genau zu fixieren, ist eine entsprechende Ausbildung der Unterseite 17a oder aber auch, je nach Art der Fixierung der Seitenwände 17b, 17c erforderlich. Auch hierfür können beispielsweise Einlegekörper in Form von Kugeln verwendet werden. Diese Einlegeteile können weit außerhalb des dargestellten Bildausschnitts an der Unterseite des Trägers 1 eingebracht werden und sind daher in den dargestellten Figuren nicht sichtbar. Kugeln haben auch in dieser Funktion den Vorteil, daß zum einen beim Einlegen die Winkelorientierung keine Rolle spielt, die benötigte Bohrung leicht zu bewerkstelligen ist, und zum andern eine problemlose Zentrierung in entsprechenden Ausnehmungen der Halterung und somit eine zuverlässig reproduzierbare Positionierung hergestellt werden kann.

Für die Bestimmung der Bezugsgeraden 14, die in Verbindung mit der hierzu senkrechten Achse 18 ein kartesisches Koordinatensystem für die genannten Berechnungen bildet, ist es von Vorteil, wenn die entsprechenden Markierungskugeln 6a, c möglichst weit auseinander liegen, um den Fehler in der Winkellage der Bezugsgeraden 14 zu minimieren.

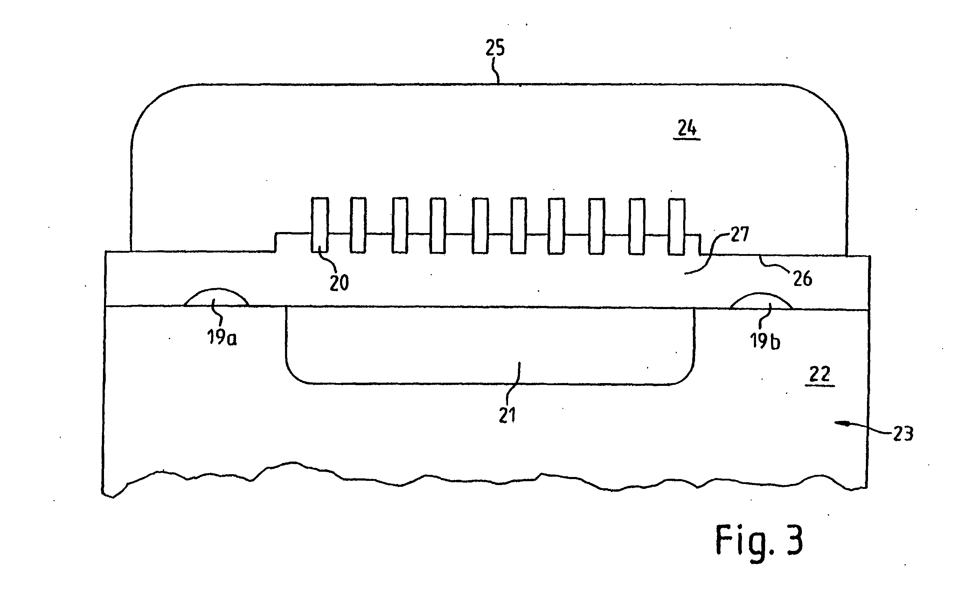

In Fig. 3 sind dementsprechend zwei Markierungskugeln 19a, b deutlich außerhalb des Meßbereichs weit voneinander beabstandet, der durch die zehn nebeneinander angeordneten Lötpins 20 eingenommen wird.

Weiterhin ist in der Darstellung gemäß Fig. 3 erkennbar, daß die Blende 21 in eine Streuplatte 22 des Chiphalters 23 aus trübem Material als schwarzes und somit total absorbierendes Eilegeteil eingefügt ist.

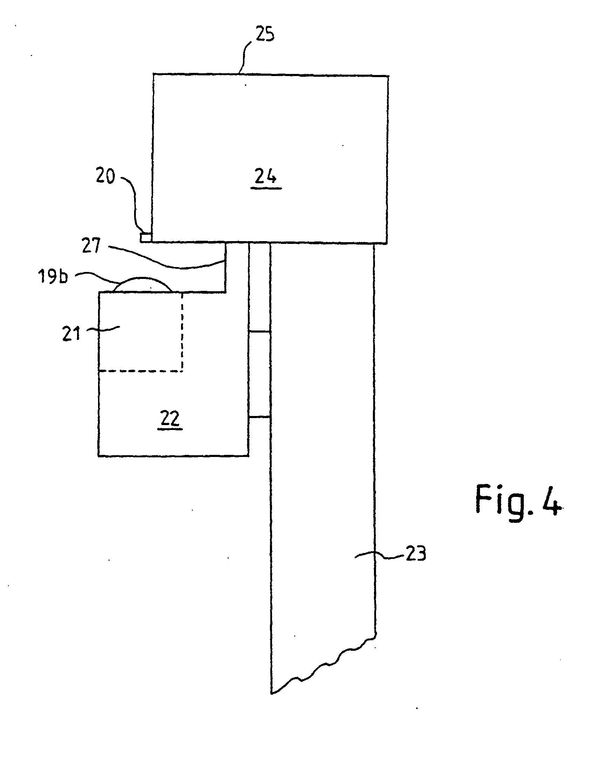

Der Chiphalter 23 gemäß Fig. 3 und 4 erstreckt sich vorliegend im Wesentlichen in vertikaler Richtung (was aus dem dargestellten Bildausschnitt nicht ersichtlich ist). Er verlängert sich demnach zur Bildunterseite hin und ist an einer vertikalen Halterung montierbar. Weiterhin ist das zu prüfende Teil nunmehr kein Chiphalter wie im vorliegenden Ausführungsbeispiel, sondern ein Stecksockel 24, der ein Metallgehäuse 25 aufweist. Die Auflageebene 26 stellt in diesem Fall die Stirnseite des Trägers 23 dar und ist nicht in eine Ausnehmung eingebettet.

Diese Ausführungsform des Trägers 23 ist insbesondere dann sinnvoll, wenn an der Rückseite des zu prüfenden Bauteils, beispielsweise des Stecksockels 24, weitere in der dargestellten Lage vertikal abstehende Strukturen vorhanden sind, die den Träger 23 auf der Rückseite hintergreifen können. Bei weiteren in der dargestellten Lage des Stecksockels 24 vertikal nach unten abstehenden Elementen im Bereich der Stirnseite des Trägers 23 können dort entsprechende Ausnehmungen, beispielsweise in Form eines Schlitzes oder dergleichen vorgenommen werden.

In einer besonderen Ausführungsform kann ein solcher Schlitz auch dadurch bewerkstelligt werden, daß ein zusätzliches Auflageteil mit einem entsprechenden Abstandshalter seitlich auf die vertikale Streuplatte 22 aufgebracht wird. Dieses zusätzliche Auflageteil kann beispielsweise dann die Sichtfläche bilden und den vertikalen Bereich 27 als Abstufung umfassen, über den die Lötpins 20 hinausragen, so daß deren unterer Rand gut sichtbar wird, wie in Fig. 3 zu erkennen ist.

Auch die Markierungskugeln 19a, b sowie die Blende 21 können dementsprechend in einem solchen zusätzlichen Auflageteil angebracht sein.

Im Falle von einem harten Außenmaterial, wie dies bei einem Metallgehäuse 25 der Fall ist, kann zur Schonung der für die verschiedenen Elemente des Trägers 23 verwendeten Kunststoffmaterialien auch der Einsatz von entsprechend härteren, beispielsweise metallenen Positionierelementen sinnvoll sein. Diese Positionierelemente können in allen Ausprägungen eines Trägers 1 oder 23 beispielsweise wiederum als Einlegeteil (in Form von Auflagekugeln, Anschlagstiften, usw.) angebracht werden.

Ein erfindungsgemäßer Werkstückträger könnte beispielsweise auch als säulenartiger Körper aus klarem, transparenten Material ausgebildet sein, an dessen oberer Stirnseite eine schmale Diffusionsplatte befestigt ist, die ihrerseits auf der Oberseite eine Auflagefläche für das Werkstück aufweist.

Wesentlich bei allen Trägern 1, 23 gemäß der Erfindung ist der Umstand, daß die Auflagefläche bzw. die in der Kamerasicht sichtbare Kante der Auflagefläche des Trägers 1, 23 vorab vermessen und in Bezug zu Markierungen 5a, b, c, 6a, b, c, 19a, b für jeden Träger 1, 23 gespeichert wird. Somit kann auch bei unscharfer Abbildung der Randkontur des Werkstücks eine zuverlässige Höhenmessung, beispielsweise von Lötpins 4a, b, c, 5a, b, c, 20 und eine hochpräzise Messung der Koplanarität dieser Lötpins vorgenommen werden.

In der Seitenansicht gemäß Figur 4 ist die Markierungskugel 19b zu sehen, die von der Streuplatte 22 aufgenommen wird. Mit einer gestrichelten Linie ist die Lage der Blende 21 angedeutet, die in der Seitenansicht nicht zu sehen ist. Die Streuplatte 22 ist mit dem Träger 23 über zwei seitlich der Blende 21 liegenden Stege verbunden. So wird zwischen der Streuplatte 22 und dem Träger 23 ein Spalt ausgebildet. Der Stecksockel 24 wird vom Träger 23 aufgenommen. Weiterhin sind die Lötpins 20 zu sehen, die über den vertikalen Bereich 27 hinausragen.

### Bezugszeichenliste

- 1: Träger
- 2: Ausnehmung
- 3: Chiphalter
- 4a, b, c: Lötpin
- 5a, b, c: Lötpin
- 6a, b, c: Markierungskugel
- 7a, b, c: Markierungskugel
- 8a, b: Kodierbohrung
- 9: Einlegeebene
- 10: Auflageebene
- 11: vertikaler Bereich
- 12: Streuplatte
- 13: Blende
- 14: Bezugsgerade
- 15: Sprung
- 16a, b, c: Maßlinie
- 17a: Unterseite
- 17b, c: Seitenwand
- 18: Achse
- 19a, b: Markierungskugel
- 20: Lötpin
- 21: Blende
- 22: Streuplatte
- 23: Träger
- 24: Stecksockel
- 25: Metallgehäuse
- 26: Auflageebene
- 27: vertikaler Bereich
- 28: Maßlinie

## Patentansprüche

1. Vorrichtung zur Vermessung von Werkstücken mit einer Bildverarbeitungsanlage, die eine Kamera, eine Auswerteeinheit und einen Träger zur Positionierung der Werkstücke vor der Kamera aufweist, wobei der Träger wenigstens eine Markierung (6a, b, c bzw. 7a, b, c) als Bezugspunkt für die Ermittlung der gewünschten Werkstückkoordinaten und eine definierte Auflagefläche (10) für das Werkstück aufweist, **dadurch gekennzeichnet, dass** die Koordinaten der Markierung (6a, b, c bzw. 7a, b, c) wenigstens teilweise in der Bildverarbeitungsanlage gespeichert sind und die Markierung ein Einlegeteil (6a, b, c bzw. 7a, b, c) umfasst.

2. Vorrichtung nach Anspruch 1, **dadurch gekennzeichnet, daß** das Einlegeteil als Kugel (6a, b, c bzw. 7a, b, c) ausgebildet ist.

3. Vorrichtung nach einem der vorgenannten Ansprüche,
**dadurch gekennzeichnet, daß** zwei Markierungen (6a, b, c bzw. 7a, b, c) vorgesehen sind.

4. Vorrichtung nach Anspruch 3, **dadurch gekennzeichnet, daß** die Auswerteeinheit für die Ermittlung des Abstands zwischen einem zu vermessenden Meßpunkt und einer durch die zwei Markierungen (6a, b, c bzw. 7a, b, c) bestimmten Bezugsgeraden (14) ausgebildet ist.

5. Vorrichtung nach Anspruch 3 oder 4, **dadurch gekennzeichnet, daß** die Markierungen (6a, b, c bzw. 7a, b, c) außerhalb des Meßbereichs liegen.

6. Vorrichtung nach Anspruch 4 oder nach Anspruch 5 wenn vom Anspruch 4 abhängig, **dadurch gekennzeichnet, daß** die Auswerteeinheit für die Ermittlung der tatsächlichen Lage des Meßpunktes bezüglich der Kontur des Werkstücks (3) aus dem Abstand des Meßpunkts von der Bezugsgeraden (14) unter Berücksichtigung der gespeicherten Trägerkoordinaten ausgebildet ist.

7. Vorrichtung nach einem der vorgenannten Ansprüche,
**dadurch gekennzeichnet, daß** ein Eichkörper zur Erfassung der Trägerkoordinaten vorgesehen ist.

8. Vorrichtung nach einem der vorgenannten Ansprüche,
**dadurch gekennzeichnet, daß** ein Streuelement (12) zur Erzeugung einer homogen diffusen Beleuchtung vorgesehen ist.

9. Vorrichtung nach einem der vorgenannten Ansprüche,
**dadurch gekennzeichnet, daß** der Träger (1) wenigstens teilweise aus transparentem, klarem Material besteht.

10. Vorrichtung nach einem der vorgenannten Ansprüche, **dadurch gekennzeichnet, daß** eine oder mehrere Blenden (13) zum Ausblenden der Beleuchtung in bestimmten Bereichen vorgesehen sind.

11. Vorrichtung nach Anspruch 10, **dadurch gekennzeichnet, daß** die Blende (13) als schwarzes Einlegeteil ausgebildet ist.

12. Vorrichtung nach einem der vorgenannten Ansprüche,
**dadurch gekennzeichnet, daß** ein definiertes Positionierungselement zur Positionierung des Trägers (1) an einer Halterung vorgesehen ist.

13. Vorrichtung nach Anspruch 12, **dadurch gekennzeichnet, daß** das Positionselement als Einlegeteil ausgebildet ist.

14. Vorrichtung nach Anspruch 12 oder 13, **dadurch gekennzeichnet, daß** das Positionselement als Kugel ausgebildet ist.

15. Vorrichtung nach einem der vorgenannten Ansprüche,
**dadurch gekennzeichnet, daß** eine Kodierung des Trägers (1) vorgesehen ist.

16. Vorrichtung nach Anspruch 15, **dadurch gekennzeichnet, daß** die Trägerkodierung wenigstens ein Einlegeteil umfaßt.

17. Vorrichtung nach Anspruch 15 oder 16, **dadurch gekennzeichnet, daß** wenigstens ein Einlegeteil der Trägerkodierung als Kugel ausgebildet ist.

18. Vorrichtung nach Anspruch 15 bis 17, **dadurch gekennzeichnet, daß** die Trägerkodierung wenigstens teilweise zugleich als Markierung für einen Bezugspunkt in der Bildauswertung vorgesehen ist.

19. Vorrichtung nach einem der vorgenannten Ansprüche,
**dadurch gekennzeichnet, daß** Saugkanäle zum Ansaugen der zu vermessenden Gegenstände vorgesehen sind, die in der Auflagefläche (10) ausmünden.

20. Verfahren zur Vermessung von Werkstücken mit einer Bildverarbeitungsanlage, die eine Kamera, eine Auswerteeinheit und einen Träger zur Positionierung der Werkstücke vor der Kamera aufweist, **dadurch gekennzeichnet, daß** ein Träger (1) nach einem der vorgenannten Ansprüche verwendet wird.

## Claims

1. Device for measuring workpieces comprising an image processing system having a camera, an evaluation unit and a carrier for positioning the workpieces in front of the camera, the carrier having at least one marking (6a, b, c or 7a, b, c) as the reference point for determining the desired workpiece coordinates and a defined supporting surface (10) for the workpiece, **characterised in that** coordinates of the marking (6a, b, c or 7a, b, c) are stored at least partially in the image processing system and the marking comprises an insert (6a, b, c or 7a, b, c).

2. Device according to claim 1, **characterised in that** the insert is formed as a sphere (6a, b, c or 7a, b, c).

3. Device according to any one of the preceding claims, **characterised in that** two markings (6a, b, c or 7a, b, c) are provided.

4. Device according to claim 3, **characterised in that** the evaluation unit is formed to determine the spacing between a measuring point to be measured and a straight reference line (14) determined by the two markings (6a, b, c or 7a, b, c).

5. Device according to claim 3 or 4, **characterised in that** the markings (6a, b, c or 7a, b, c) are outside the measuring region.

6. Device according to claim 4 or according to claim 5 if dependent on claim 4, **characterised in that** the evaluation unit is formed to determine the actual position of the measuring point with respect to the contour of the workpiece (3), from the distance of the measuring point from the straight reference line (14), taking into account the stored carrier coordinates.

7. Device according to any one of the preceding claims, **characterised in that** a calibration member is provided for detecting the carrier coordinates.

8. Device according to any one of the preceding claims, **characterised in that** a scattering element (12) is provided to generate homogeneous diffuse lighting.

9. Device according to any one of the preceding claims, **characterised in that** the carrier (1) consists at least partially of transparent, clear material.

10. Device according to any one of the preceding claims, **characterised in that** one or more screens (13) are provided to screen out the lighting in specific regions.

11. Device according to claim 10, **characterised in that** the screen (13) is formed as a black insert.

12. Device according to any one of the preceding claims, **characterised in that** a defined positioning element is provided for positioning the carrier (1) on a holder.

13. Device according to claim 12, **characterised in that** the positioning element is formed as a insert.

14. Device according to claim 12 or 13, **characterised in that** the positioning element is formed as a sphere.

15. Device according to any one of the preceding claims, **characterised in that** a coding is provided for the carrier (1).

16. Device according to claim 15, **characterised in that** the carrier coding comprises at least one insert.

17. Device according to claim 15 or 16, **characterised in that** at least one insert of the carrier coding is formed as a sphere.

18. Device according to claim 15 to 17, **characterised in that** the carrier coding is simultaneously provided, at least partially, as a marking for a reference point in the image evaluation.

19. Device according to any one of the preceding claims, **characterised in that** suction channels opening in the support face (10) are provided to suck in the objects to be measured.

20. Method for measuring workpieces comprising an image processing system having a camera, an evaluation unit and a carrier for positioning the workpieces in front of the camera, **characterised in that** a carrier (1) is used according to any one of the preceding claims.

## Revendications

1. Dispositif pour mesurer des pièces ayant une installation de traitement d'images, qui présente une caméra, une unité d'exploitation, et un support pour positionner les pièces devant la caméra, le support présentant au moins un repère (6a, b, c ou 7a, b, c) comme point de référence pour la détermination des coordonnées souhaitées de la pièce et une surface d'appui définie (10) pour la pièce,
**caractérisé en ce que** les coordonnées du repère (6a, b, c ou 7a, b, c) sont mémorisées au moins en partie dans l'installation de traitement d'images et le repère comporte une pièce d'insertion (6a, b, c ou 7a, b, c).

2. Dispositif selon la revendication 1,
**caractérisé en ce que** la pièce d'insertion est réalisée comme bille (6a, b, c ou 7a, b, c).

3. Dispositif selon une des revendications précitées,
**caractérisé en ce que** deux repères (6a, b, c ou 7a, b, c) sont prévus.

4. Dispositif selon la revendication 3,
**caractérisé en ce que** l'unité d'exploitation est réalisée pour déterminer la distance entre un point de mesure à mesurer et une droite de référence (14) déterminée par les deux repères (6a, b, c ou 7a, b, c).

5. Dispositif selon la revendication 3 ou 4,
**caractérisé en ce que** les repères (6a, b, c ou 7a, b, c) se trouvent à l'extérieur de la zone de mesure.

6. Dispositif selon la revendication 4 ou la revendication 5 quand elle dépend de la revendication 4,
**caractérisé en ce que** l'unité d'exploitation pour déterminer la position effective du point de mesure relativement au contour de la pièce (3) à partir de la distance du point de mesure de la droite de référence (14) est réalisée en tenant compte des coordonnées mémorisées du support.

7. Dispositif selon une des revendications précitées,
**caractérisé en ce qu'**un corps d'étalonnage pour déterminer les coordonnées du support est prévu.

8. Dispositif selon une des revendications précitées,
**caractérisé en ce qu'**un élément de diffusion (12) est prévu pour engendrer un éclairage diffus homogène.

9. Dispositif selon une des revendications précitées,
**caractérisé en ce que** le support (1) est constitué au moins partiellement d'une matière transparente limpide.

10. Dispositif selon une des revendications précitées,
**caractérisé en ce qu'**un ou plusieurs écrans (13) sont prévus pour supprimer l'éclairage dans des zones déterminées.

11. Dispositif selon la revendication 10,
**caractérisé en ce que** l'écran (13) est réalisé comme pièce d'insertion noire.

12. Dispositif selon une des revendications précitées,
**caractérisé en ce qu'**un élément de positionnement défini pour positionner le support (1) sur un moyen de fixation est prévu.

13. Dispositif selon la revendication 12,
**caractérisé en ce que** l'élément de positionnement est réalisé comme pièce d'insertion.

14. Dispositif selon la revendication 12 ou 13,
**caractérisé en ce que** l'élément de positionnement est réalisé comme bille.

15. Dispositif selon une des revendications précitées,
**caractérisé en ce qu'**un codage du support (1) est prévu.

16. Dispositif selon la revendication 15,
**caractérisé en ce que** le codage du support comporte au moins une pièce d'insertion.

17. Dispositif selon la revendication 15 ou 16,
**caractérisé en ce qu'**au moins une pièce d'insertion du codage du support est réalisée comme bille.

18. Dispositif selon les revendications 15 à 17,
**caractérisé en ce que** le codage du support est prévu au moins partiellement en même temps comme repère pour un point de référence dans l'exploitation d'images.

19. Dispositif selon une des revendications précitées,
**caractérisé en ce que** des canaux d'aspiration pour aspirer les objets à mesurer sont prévus, lesquels débouchent dans la surface d'appui (10).

20. Procédé pour mesurer des pièces avec une installation de traitement d'images, qui présente une caméra, une unité d'exploitation, et un support pour positionner les pièces devant la caméra,
**caractérisé en ce qu'**un support (1) selon une des revendications précitées est utilisé.
